(19) **Europäisches Patentamt / European Patent Office / Office européen des brevets**

(11) **EP 2 402 774 B1**

(12) **EUROPEAN PATENT SPECIFICATION**

(45) Date of publication and mention
of the grant of the patent:
**15.05.2013 Bulletin 2013/20**

(51) Int Cl.:
*G01R 31/08* (2006.01)    *H02H 3/40* (2006.01)

(21) Application number: **10167650.0**

(22) Date of filing: **29.06.2010**

(54) **Method and apparatus for determining distance to phase-to-earth fault**

Verfahren und Vorrichtung zur Bestimmung der Distanz zu Phase-Erde-Schluss

Procédé et appareil pour définir la distance d'un défaut de phase à la terre

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(43) Date of publication of application:
**04.01.2012 Bulletin 2012/01**

(73) Proprietor: **ABB Technology AG
8050 Zürich (CH)**

(72) Inventors:
• **Wahlroos, Ari
65350 Vaasa (FI)**
• **Altonen, Janne
37800 Toijala (FI)**

(74) Representative: **Valkeiskangas, Tapio Lassi
Paavali
Kolster Oy Ab
Iso Roobertinkatu 23
P.O. Box 148
00121 Helsinki (FI)**

(56) References cited:
EP-A1- 0 106 790    EP-A1- 1 739 441
EP-A1- 1 939 638    EP-A1- 1 992 954
EP-A1- 2 000 811    EP-A1- 2 006 694

EP-A2- 0 665 625    EP-A2- 0 795 944
EP-A2- 1 195 875    EP-A2- 1 304 580
EP-A2- 1 724 597    DE-A1- 4 026 799
DE-A1- 4 429 310    DE-C1- 10 143 595
JP-A- 2000 227 453

• HÄNNINEN S ET AL: "Earth fault distance computation with fundamental frequency signals based on measurements in substation supply bay", INTERNET CITATION, 2002, XP002454683, Retrieved from the Internet: URL:http://web.archive.org/web/20061230171 424/virtual.vtt.fi/inf/pdf/tied otteet/2002/T2153.pdf [retrieved on 2007-10-08]

• NIKANDER A ET AL: "NOVEL ALGORITHMS FOR EARTH FAULT INDICATION BASED ON MONITORING OF SHUNT RESISTANCE OF MV FEEDER AS A PART OF RELAY PROTECTION", INTERNATIONAL CONFERENCE ON DEVELOPMENTS IN POWER SYSTEMPROTECTION, XX, XX, 9 April 2001 (2001-04-09), pages 430-433, XP008053503,

• NIKANDER A ET AL: "Methods for earth fault identification and distance estimation in a compensated medium voltage distribution network", ENERGY MANAGEMENT AND POWER DELIVERY, 1998. PROCEEDINGS OF EMPD '98. 1 998 INTERNATIONAL CONFERENCE ON SINGAPORE 3-5 MARCH 1998, NEW YORK, NY, USA,IEEE, US, vol. 2, 3 March 1998 (1998-03-03), pages 595-600, XP010293689, DOI: DOI: 10.1109/EMPD.1998.702754 ISBN: 978-0-7803-4495-2

**Description**

FIELD OF THE INVENTION

The invention relates to determining a distance to a phase-to-earth fault on a three-phase electric line of an electric network.

BACKGROUND OF THE INVENTION

Distribution networks with their neutral point earthed through a Petersen coil are becoming increasingly popular worldwide. The main advantage of the compensation is the decreased number of customer outages as earth faults become often self-extinguished due to a decreased earth fault current. However, the small fault current poses challenges to the protection of the systems and challenges especially fault location.
Document "Earth fault distance computation with fundamental frequency signals based on measurements in substation supply bay"; Seppo Hänninen, Matti Lehtonen; VTT Research Notes 2153; Espoo 2002, discloses an example of a method for fault localization of single phase earth faults in Petersen coil compensated networks. The disclosed method utilizes changes of measured quantities (noted as Δ) during the fault. The change during the fault is obtained by changing the impedance of the compensation coil. In practice this means connection or disconnection of the parallel resistor of the compensation coil. The method is based on measurements in a substation supply bay. The fault distance calculation procedure contains the following steps:

Step #1: Detection of the switching on or off of the parallel resistor of the suppression coil.
Step #2: Identification of a faulty phase by monitoring the amplitudes of phase-to-earth voltages. Knowledge of the faulted phase is imperative, as it determines the selection of quantities used in the disclosed fault distance calculation.
Step #3: The fault current change is assumed to be: $\Delta \bar{I}_F = 3 * \Delta \bar{I}_2$,
where $\Delta \bar{I}_2$ is the change in the negative sequence component (measurement after the change (2) minus measurement prior to the change (1) during the fault).
Step #4: The voltage change is the change of voltage in the faulty phase, e.g. fault in phase L1:

$$\Delta \bar{U}_R = \bar{U}_{R(2)} - \bar{U}_{R(1)}$$

Step #5: The fault distance d (in per unit of line length) can be solved:

$$d = 3 * imag(\Delta \bar{U}_R / \Delta \bar{I}_F) / (X_1 + X_2 + X_0) \text{ [p.u.]},$$

where $X_0$, $X_1$, $X_2$ are the zero, positive and negative sequence reactances of the line.
EP 1304580 describes a fault distance calculation method for compensated networks, which also utilizes changes of measured quantities during the fault. The disclosed method is based on measurement on a feeder bay and the equations used in fault distance calculation are derived from a well known symmetrical component equivalent circuit valid for a single phase earth fault. The fault current change $\Delta \bar{I}_F$ is based on the measured residual current and setting $\overline{Y}_{00\text{-Leitung}}$, which represents the zero-sequence admittance of the protected line, is used for improving the accuracy of fault current change estimate.
Both of the above-described methods have the drawback that all phase-to-earth voltages and all phase currents must be available for the calculation of fault distance. This is often a limitation in practice as these values are not necessarily readily available and might thus require additional measuring arrangements. In addition, the use of phase voltages in the fault distance calculation requires a secure faulted phase identification procedure, otherwise the calculation procedure fails.

BRIEF DESCRIPTION OF THE INVENTION

An object of the present invention is thus to provide a method and an apparatus for implementing the method so as to overcome the above problems or at least to alleviate them. The objects of the invention are achieved by a method and an arrangement which are characterized by what is stated in the independent claims. The preferred embodiments of the invention are disclosed in the dependent claims.

The invention is based on the idea of using a change in a residual voltage of the electric network as an approximation of a change in a voltage in the faulty phase. In addition, the invention is based on modeling the zero sequence circuit of the electric network.

An advantage of the method and arrangement of the invention is that only the residual voltage and zero sequence current values are needed for the distance calculation instead of all phase-to-earth voltages and all phase currents. The residual voltage and the zero sequence current values are typically readily available and thus the implementation of the invention into existing systems typically does not require additional measuring arrangements.

BRIEF DESCRIPTION OF THE DRAWINGS

In the following the invention will be described in greater detail by means of preferred embodiments with reference to the accompanying drawings, in which

Figure 1 is a diagram illustrating an electric network; and
Figure 2 is an equivalent scheme according to an embodiment.

DETAILED DESCRIPTION OF THE INVENTION

The application of the invention is not limited to any specific system, but it can be used in connection with various three-phase electric systems to determine a distance to a phase-to-earth fault on a three-phase electric line of an electric network. The electric line can be a feeder, for example, and may be an overhead-line or a cable or a combination thereof. The electric power system in which the invention is implemented can be an electric transmission or distribution network or a component thereof, for example, and may comprise several feeders or sections. Moreover, the use of the invention is not limited to systems employing 50 Hz or 60 Hz fundamental frequencies or to any specific voltage level.

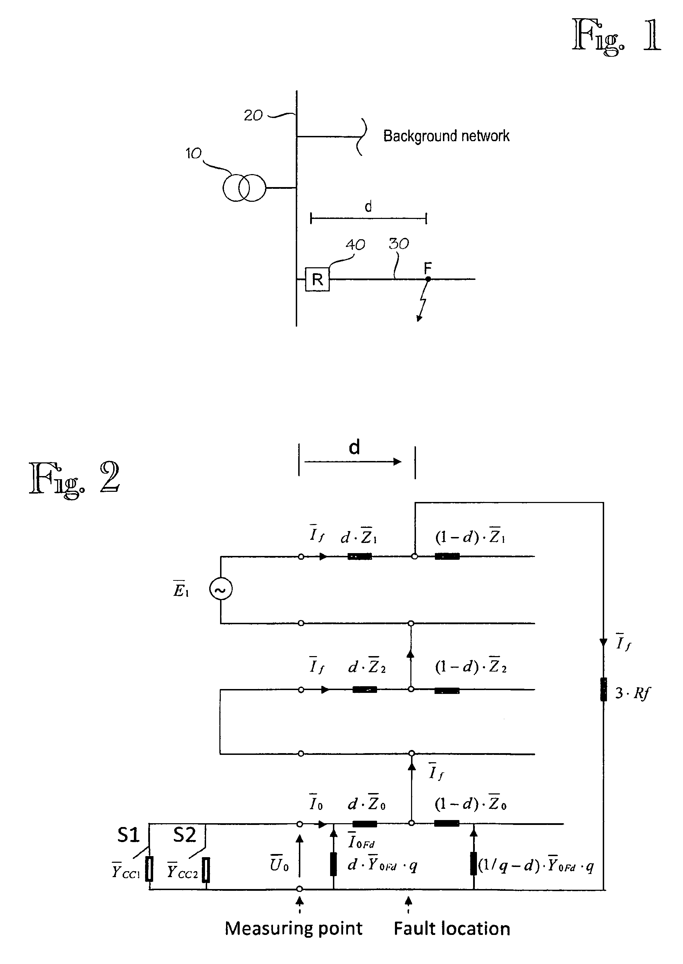

Figure 1 is a simplified diagram illustrating an electric network in which the invention can be applied. The figure shows only the components necessary for understanding the invention. The exemplary network can be a medium voltage (e.g. 20 kV) distribution network fed through a substation comprising a transformer 10 and a busbar 20. The illustrated network also comprises electric line outlets, i.e. feeders, of which one 30 is shown separately. Other possible feeders as well as other network parts, except the line 30, are referred to as a 'background network'. The figure also shows a protective relay unit 40 at the beginning of line 30, and a point of earth fault F. The protective relay unit 40 may be located inside the substation. It should be noted that there may be any number of feeders or other network elements in the network. There may also be several feeding substations. Further, the invention can be utilized with a switching station without a transformer 10, for example. The network is a three-phase network, although, for the sake of clarity, the phases are not shown in the figure. In the exemplary system of Figure 1, the functionality of the invention may be located in the relay unit 40, for example. It is also possible that e.g. only some measurements are performed at the location of unit 40 and the results are then transmitted to another unit or units (not shown in the figures) in another location for further processing. In other words, the relay unit 40 could be a mere measuring unit, while the functionality of the invention, or part of it, could be located in another unit or units.

Current and voltage values that are needed in the following embodiments may be obtained by a suitable measuring arrangement including e.g. current and voltage transducers (not shown in the figures). In most of the existing protection systems, such values are readily available and thus the implementation of the various embodiments does not necessarily require any additional measuring arrangements. The residual voltage of the electric network may be determined from phase voltages or by measuring it from an open delta winding formed by voltage transformers, for example. The zero-sequence current of the electric line 30 may be determined with a suitable current measuring arrangement at the measuring point such as the relay unit 40. How these values are obtained is of no relevance to the basic idea of the invention and depends on the particular electricity system. A phase-to-earth fault F occurring on the three-phase electric line 30 may be detected e.g. by the protective relay 40 associated with the electricity system. The particular way how such faults are detected is, however, of no relevance to the basic idea of the invention.

According to an embodiment the distance to the fault F from a measuring point, such as the relay unit 40, may be determined by utilizing changes in a residual voltage of the electric network and in a zero-sequence current of the electric line 30 at the measuring point during a phase-to-earth fault when a neutral to earth admittance of the electric network outside the electric line 30 changes from a first value to a second value different from the first value. The change during the fault may be obtained by changing the impedance of a compensation coil, for example. Typically this means the connection or disconnection of a parallel resistor of a compensation coil or a change in the compensation degree of the compensation coil. But the change can be any change in the neutral to earth admittance of the electric network outside the electric line 30 during the fault, which leads to change in the magnitudes of the voltages and currents. Therefore the invention is not limited to Petersen coil compensated networks.

The event that initiates the distance computation may be an external signal from the compensation equipment indicating e.g. the connection of the parallel resistor or another change. Alternatively, the event that initiates the distance computation may be an internally monitored change, delta, in a resistive current component of a residual current:

$$\Delta Io \cos\phi = \text{abs}(3\overline{I}_{02}) \cos\phi_2 - abs(3\overline{I}_{01}) \cos\phi_1 ,$$

where

$\overline{I}_{02}$ = zero-sequence current of the electric line after the change
$\overline{U}_{02}$ = residual voltage of the system after the change
$\phi_2$ = angle difference between $\overline{U}_{02}$ and $\overline{I}_{02}$
$\overline{I}_{01}$ = zero-sequence current of the electric line prior the change
$\overline{U}_{01}$ = residual voltage of the system prior the change
$\phi_1$ = angle difference between $\overline{U}_{01}$ and $\overline{I}_{01}$

In other words, the change in the neutral to earth admittance of the electric network from the first value to the second value may be detected by monitoring the resistive current component of the measured residual current. As the ampere value of a possible parallel resistor is known beforehand, a corresponding threshold limit for the change in the resistive current component of the residual current during the fault can be easily defined accordingly. Thus, according to an embodiment, the neutral to earth admittance of the electric network is determined to have changed from the first value to the second value when the resistive current component of the measured residual current changes at least by a predetermined threshold.

Figure 2 illustrates an equivalent scheme of a phase-to-earth fault on an electric line. Based on the equivalent scheme the following equation can be written. The change of the quantities refers to a change which results from a change in the neutral to earth admittance outside of the electric line. In the exemplary case of the Figure 2, this can be accomplished e.g. by connecting admittance $\overline{Y}_{CC2}$ instead of admittance $\overline{Y}_{CC1}$, using switches S1 and S2, which thus represents, for instance, the connection or disconnection of a parallel resistor of a possible compensation coil or a change in the compensation degree of the compensation coil.

$$\Delta\overline{U}_0 = d \cdot \overline{Z}_0 \cdot (\Delta\overline{I}_0 + \Delta\overline{I}_{0Fd}) + d \cdot \overline{Z}_2 \cdot \Delta\overline{I}_f + d \cdot \overline{Z}_1 \cdot \Delta\overline{I}_f + 3 \cdot R_f \cdot \Delta\overline{I}_f ,$$

(Eq. 1)

where

$\Delta\overline{U}_0$ = change in the residual voltage ($\overline{U}_0$) during the fault (volts)
$d$ = fault distance in per unit (p.u.) between the measuring point and fault location
$\overline{Z}_0$ = zero-sequence impedance of the electric line (ohms)
$\Delta\overline{I}_0$ = change in the zero-sequence current ($\overline{I}_0$) of the electric line at the measuring point during the fault (amperes)
$\Delta\overline{I}_{0Fd}$ = change in the zero-sequence charging current of the electric line ($\overline{I}_{0Fd}$) during the fault (amperes)
$\overline{Z}_2$ = negative-sequence impedance of the electric line (ohms)
$\Delta\overline{I}_f$ = change in the fault current ($\overline{I}_f$) during the fault (amperes)
$\overline{Z}_1$ = positive-sequence impedance of the electric line (ohms)
$R_f$ = fault resistance (ohms) in the fault point

For cables and overhead-lines applies:

$\overline{Z}_2 = \overline{Z}_1$ negative sequence impedance equals the positive sequence impedance.

The change in the zero-sequence charging current of the electric line which flows through the zero-sequence impedance during the fault is:

$$\Delta \overline{I}_{0Fd} = -\Delta \overline{U}_0 \cdot \overline{Y}_{0Fd} \cdot d \cdot q , \qquad \text{(Eq. 2)}$$

where

$\overline{Y}_{0Fd}$ = Admittance of the electric line (Siemens), setting
$q$ = Parameter and $0 < q \leq 1$; used for estimating how large a portion of the capacitive current of the electric line flows through the zero-sequence impedance during the fault. In case of evenly distributed capacitance, then q equals 0.5. If the electric line has e.g. large branch lines before its midpoint, then the value of q should be below 0.5. If the electric line has e.g. large branch lines after its midpoint, then the value of q should be over 0.5.

The change in the fault current during the fault is:

$$\Delta \overline{I}_f = \Delta \overline{I}_0 - \Delta \overline{U}_0 \cdot \overline{Y}_{0Fd} \qquad \text{(Eq. 3)}$$

Inserting equations 2 and 3 into equation 1, calculating real and imaginary parts and finally solving the equations, gives a second order equation for the fault distance d, which is of form:

$$a^*d^2 + b^*d + c = 0,$$

where

a = (imI0*reZ0U0Y0*q - imU0Y0*reZ0U0Y0*q - imZ0U0Y0*q*reI0 + imZ0U0Y0*q*reU0Y0)
b = (2*imI0*reZ1U0Y0 - imI0*reZ0I0 + imU0Y0*reZ0I0 - 2*imI0*reZ1I0 + 2*imU0Y0*reZ1I0 - 2*imU0Y0*reZ1U0Y0 - 2*reI0*imZ1U0Y0 + 2*reU0Y0*imZ1U0Y0 + reI0*imZ0I0 - reU0Y0*imZ0I0 + 2*reI0*imZ1I0 - 2*reU0Y0*imZ1I0); and
c = imI0*reU0 - imU0Y0*reU0 - imU0*reI0 + imU0*reU0Y0,

where

relI0 = real($\Delta \overline{I}_0$);
imI0 = imag($\Delta \overline{I}_0$);
reU0 = real($\Delta \overline{U}_0$);
imU0 = imag($\Delta \overline{U}_0$);
reZ0U0Y0 = real($\overline{Z}_0 \cdot \Delta \overline{U}_0 \cdot \overline{Y}_{0Fd}$);
imZ0U0Y0 = imag($\overline{Z}_0 \cdot \Delta \overline{U}_0 \cdot \overline{Y}_{0Fd}$);
reU0Y0 = reat($\Delta \overline{U}_0 \cdot \overline{Y}_{0Fd}$);
imU0Y0 = imag($\Delta \overline{U}_0 \cdot \overline{Y}_{0Fd}$);
reZ1I0 = real($\overline{Z}_1 \cdot \Delta \overline{I}_0$);
imZ1I0 = imag($\overline{Z}_1 \cdot \Delta \overline{I}_0$);
reZ1U0Y0 = real($\overline{Z}_1 \cdot \Delta \overline{U}_0 \cdot \overline{Y}_{0Fd}$);
imZ1U0Y0 = imag($\overline{Z}_1 \cdot \Delta \overline{U}_0 \cdot \overline{Y}_{0Fd}$);
reZ0I0 = real($\overline{Z}_0 \cdot \Delta \overline{I}_0$);
imZ0I0 = imag($\overline{Z}_0 \cdot \Delta \overline{I}_0$).

Thus, the distance d to the phase-to-earth fault from the measuring point may be determined from the above second order equation. According to an embodiment, the solutions for fault distance d are (d1 and d2):

$$d1 = \frac{-b + \sqrt{b^2 - 4 \cdot a \cdot c}}{2 \cdot a} ,$$

and

$$d2 = \frac{-b - \sqrt{b^2 - 4 \cdot a \cdot c}}{2 \cdot a}.$$

The fault distance may then be determined as follows: d = d1 if d1 is between 0...1 (possibly with some tolerance to cover e.g. possible measurement errors); otherwise d = d2.

According to an embodiment, a faulted phase identification can be made utilizing phase currents and residual voltage measurements according to the following procedure:

1. Calculate

$$R_{F0} = re\left(\frac{\Delta \overline{U}_0}{3 \cdot \Delta \overline{\overline{I}}_0}\right)$$

2. Calculate:

$$R_{F\_L1} = re\left(\frac{\Delta \overline{U}_0}{3 \cdot \Delta \overline{I}_{2L1}}\right)$$

$$R_{F\_L2} = re\left(\frac{\Delta \overline{U}_0}{3 \cdot \Delta \overline{I}_{2L2}}\right)$$

$$R_{F\_L3} = re\left(\frac{\Delta \overline{U}_0}{3 \cdot \Delta \overline{I}_{2L3}}\right)$$

where

$$\overline{I}_{2L1} = \left(\overline{I}_{L1} + \overline{a}^2 \cdot \overline{I}_{L2} + \overline{a} \cdot \overline{I}_{L3}\right)/3$$

$$\overline{I}_{2L2} = \left(\overline{a} \cdot \overline{I}_{L1} + \overline{I}_{L2} + \overline{a}^2 \cdot \overline{I}_{L3}\right)/3$$

$$\overline{I}_{2L3} = \left(\overline{a}^2 \cdot \overline{I}_{L1} + \overline{a} \cdot \overline{I}_{L2} + \overline{I}_{L3}\right)/3$$

L1, L2, L3 = phases 1, 2 and 3, respectively
Δ refers to a change in the quantity due to a change during a fault which results from a change in the neutral to earth admittance outside of the electric line

3. Calculate differences:

Diff_L1 = abs(R_{F0} - R_{F\_L1})
Diff_L2 = abs(R_{F0} - R_{F\_L2})
Diff_L3 = abs(R_{F0} - R_{F\_L3})

4. Faulted phase is the one with minimum Diff_L-value.

According to an embodiment, the fault resistance $R_F$ (in ohms) can be estimated using equation:

When

$$re\left(\frac{\Delta \overline{U}_0}{3 \cdot \Delta \overline{\overline{I}}_0}\right) < 100 \ \text{ohm}$$

$$R_F = re\left(\frac{\Delta \overline{U}_0}{\Delta \overline{I}_f}\right) - d \cdot (2 * R_1 + R_0)/3 \approx \left[re\left(\frac{\Delta \overline{U}_0}{\Delta \overline{\overline{I}}_f}\right) - d \cdot R_1\right] \text{[ohm]}$$

When

$$re\left(\frac{\Delta \overline{U}_0}{3 \cdot \Delta \overline{\overline{I}}_0}\right) \geq 100 \ \text{ohm}$$

$$R_F == re\left(\frac{\Delta \overline{U}_0}{\Delta \overline{I}_f}\right) \text{[ohm]}$$

where
$R_0$, $R_1$ = Zero and positive sequence resistance (ohm) of the electric line.
The logic is based on the fact that fault resistance estimate should not be dependent on the calculated fault distance d with higher value of $R_F$ as d becomes corrupted. It should be taken into account only when $R_F \approx$ <100 ohm, i.e. when the fault location calculation is capable of producing reliable values. The fault resistance estimate can be used as such to give additional information about the characteristics of the fault; whether it is a low or high ohmic earth fault. The fault resistance estimate can also be used for judging the validity of the calculated fault distance estimate. The calculated fault distance estimate is typically more accurate when the fault resistance is low, e.g. $R_F \approx$ <100 ohm. It is therefore preferable to judge the validity of calculated fault distance estimate and this can be done reliably utilizing the fault resistance estimation.
An apparatus according to any one of the above embodiments, or a combination thereof, may be implemented as a single unit or as two or more separate units that are configured to implement the functionality of the various embodiments. Here the term 'unit' refers generally to a physical or logical entity, such as a physical device or a part thereof or a software routine. One or more of these units may reside in the protective relay unit 40, for example.
An apparatus according to any one of the embodiments may be implemented by means of a computer or corresponding digital signal processing equipment provided with suitable software, for example. Such a computer or digital signal processing equipment preferably comprises at least a working memory (RAM) providing storage area for arithmetical operations and a central processing unit (CPU), such as a general-purpose digital signal processor. The CPU may comprise a set of registers, an arithmetic logic unit, and a control unit. The control unit is controlled by a sequence of program instructions transferred to the CPU from the RAM. The control unit may contain a number of microinstructions for basic operations. The implementation of the microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the invention further preferably comprises suitable input means for receiving e.g. measurement and/or control data, which input means thus enable e.g. the monitoring of current and voltage quantities, and output means for outputting e.g. calculation results and/or control data. It is also possible to use a specific integrated circuit or circuits, or corresponding components and devices for implementing the functionality according to any one of the embodiments.

The invention can be implemented in existing system elements, such as various protective relays or relay arrangements, or by using separate dedicated elements or devices in a centralized or distributed manner. Present protective devices for electric systems, such as protective relays, typically comprise processors and memory that can be utilized in the functions according to embodiments of the invention. Thus, all modifications and configurations required for implementing an embodiment of the invention e.g. in existing protective devices may be performed as software routines, which may be implemented as added or updated software routines. If the functionality of the invention is implemented by software, such software can be provided as a computer program product comprising computer program code which, when run on a computer, causes the computer or corresponding arrangement to perform the functionality according to the invention as described above. Such a computer program code may be stored or generally embodied on a computer readable medium, such as suitable memory means, e.g. a flash memory or a disc memory from which it is loadable to the unit or units executing the program code. In addition, such a computer program code implementing the invention may be loaded to the unit or units executing the computer program code via a suitable data network, for example, and it may replace or update a possibly existing program code.

It will be obvious to a person skilled in the art that, as the technology advances, the inventive concept can be implemented in various ways. The invention and its embodiments are not limited to the examples described above but may vary within the scope of the claims.

## Claims

**1.** A method for determining a distance to a phase-to-earth fault on a three-phase electric line of an electric network, the method comprising:

determining, during a phase-to-earth fault (F) on the three-phase electric line (30), values of a residual voltage of the electric network and a zero-sequence current of the electric line at a measuring point (40) when a neutral to earth admittance of the electric network outside the electric line (30) has a first value and when the neutral to earth admittance of the electric network outside the electric line has a second value different from the first value; and

determining the distance to the phase-to-earth fault (F) from the measuring point (40) on the basis of the determined residual voltage and zero-sequence current values, **characterized in that** the distance is determined using the following equation:

$$a^*d^2 + b^*d + c = 0$$

where

$d$ = fault distance in per unit (p.u.)

$a = (\mathrm{imag}(\Delta \bar{I}_0)^* \mathrm{rea})(\bar{Z}_0 \cdot \Delta \bar{U}_0 \cdot \bar{Y}_{0Fd})^*q - \mathrm{imag}(\Delta \bar{U}_0 \cdot \bar{Y}_{0Fd})^* \mathrm{real}(\bar{Z}_0 \cdot \Delta \bar{U}_0 \cdot \bar{Y}_{0Fd})^*q - \mathrm{imag}(\bar{Z}_0 \cdot \Delta \bar{U}_0 \cdot \bar{Y}_{0Fd})^*q^* \mathrm{real}(\Delta \bar{I}_0) + \mathrm{imag}(\bar{Z}_0 \cdot \Delta \bar{U}_0 \cdot \bar{Y}_{0Fd})^*q^* \mathrm{real}(\Delta \bar{U}_0 \cdot \bar{Y}_{0Fd}))$;

$b = (2^* \mathrm{imag}(\Delta \bar{I}_0)^* \mathrm{real}(\bar{Z}_1 \cdot \Delta \bar{U}_0 \cdot \bar{Y}_{0Fd}) - \mathrm{imag}(\Delta \bar{I}_0)^* \mathrm{real}(\bar{Z}_0 \cdot \Delta I_0) + \mathrm{imag}(\Delta \bar{U}_0 \cdot \bar{Y}_{0Fd})^* \mathrm{real}(\bar{Z}_0 \cdot \Delta I_0) - 2^* \mathrm{imag}(\Delta \bar{I}_0)^* \mathrm{real}(\bar{Z}_1 \cdot \Delta I_0) + 2^* \mathrm{imag}(\Delta \bar{U}_0 \cdot Y_{0Fd})^* \mathrm{real}(Z_1 \cdot \Delta I_0) - 2^* \mathrm{imag}(\Delta \bar{U}_0 \cdot \bar{Y}_{0Fd})^* \mathrm{real}(\bar{Z}_1 \cdot \Delta \bar{U}_0 \cdot \bar{Y}_{0Fd}) - 2^* \mathrm{real}(\Delta \bar{I}_0)^* \mathrm{imag}(\bar{Z}_1 \cdot \Delta \bar{U}_0 \cdot \bar{Y}_{0Fd}) + 2^* \mathrm{real}(\Delta \bar{U}_0 \cdot \bar{Y}_{0Fd})^* \mathrm{imag}(\bar{Z}_1 \cdot \Delta \bar{U}_0 \cdot \bar{Y}_{0Fd}) + \mathrm{real}(\Delta \bar{I}_0)^* \mathrm{imag}(\bar{Z}_0 \cdot \Delta I_0) - \mathrm{real}(\Delta \bar{U}_0 \cdot \bar{Y}_{0Fd})^* \mathrm{imag}(\bar{Z}_0 \cdot \Delta I_0) + 2^* \mathrm{real}(\Delta \bar{I}_0)^* \mathrm{imag}(\bar{Z}_1 \cdot \Delta I_0) - 2^* \mathrm{real}(\Delta \bar{U}_0 \cdot \bar{Y}_{0Fd})^* \mathrm{imag}(\bar{Z}_1 \cdot \Delta I_0))$; and

$c = \mathrm{imag}(\Delta \bar{I}_0)^* \mathrm{real}(\Delta \bar{U}_0) - \mathrm{imag}(\Delta \bar{U}_0 \cdot \bar{Y}_{0Fd})^* \mathrm{real}(\Delta \bar{U}_0) - \mathrm{imag}(\Delta \bar{U}_0)^* \mathrm{real}(\Delta \bar{I}_0) + \mathrm{imag}(\Delta \bar{U}_0)^* \mathrm{real}(\Delta \bar{U}_0 \cdot \bar{Y}_{0Fd})$,

where

$\overline{Z}_0$ = zero-sequence impedance of the electric line
$\overline{Z}_1$ = positive-sequence impedance of the electric line
$\overline{Y}_{0Fd}$ = admittance of the electric line
$\Delta \overline{U}_0$ = change in the residual voltage when the neutral to earth admittance of the electric network changes from the first value to the second value
$\Delta \overline{I}_0$ = change in the zero-sequence current when the neutral to earth admittance of the electric network changes from the first value to the second value
q = parameter and $0 < q \leq 1$.

2. A method as claimed in claim 1, **characterized in that**

$$d1 = \frac{-b + \sqrt{b^2 - 4 \cdot a \cdot c}}{2 \cdot a} \; ;$$

and

$$d2 = \frac{-b - \sqrt{b^2 - 4 \cdot a \cdot c}}{2 \cdot a} \; ,$$

wherein the distance d to the phase-to-earth fault (F) from the measuring point (40) is determined as follows: d = d1 if $0 \leq d1 \leq 1$, otherwise d = d2.

3. A method as claimed in claim 1 or 2, **characterized in that** the change in the neutral to earth admittance of the electric network outside the electric line (30) from the first value to the second value is detected by monitoring a resistive current component of a residual current of the electric line (30).

4. A method as claimed in claim 3, **characterized in that** the neutral to earth admittance of the electric network outside the electric line (30) is determined to have changed from the first value to the second value when the resistive current component of the residual current of the electric line (30) changes at least by a predetermined threshold.

5. A method as claimed in any one of claims 1 to 4, **characterized in that** q is approximately 0.5.

6. A computer program product comprising computer program code, wherein execution of the program code in a computer causes the computer to carry out the steps of the method according to any one of claims 1 to 5.

7. An apparatus for determining a distance to a phase-to-earth fault on a three-phase electric line of an electric network, the apparatus comprising:

means (40) for determining, during a phase-to-earth fault (F) on the three-phase electric line (30), values of a residual voltage of the electric network and a zero-sequence current of the electric line at a measuring point (40) when a neutral to earth admittance of the electric network outside the electric line (30) has a first value and when the neutral to earth admittance of the electric network outside the electric line has a second value different from the first value; and
means (40) for determining the distance to the phase-to-earth fault (F) from the measuring point (40) on the basis of the determined residual voltage and zero-sequence current values, **characterized in that** the means (40) for determining the distance are configured to determine the distance using the following equation:

$$a^*d^2 + b^*d + c = 0$$

where

d = fault distance in per unit (p.u.)

$a = (\text{imag}(\Delta\bar{I}_0)*\text{real}(\bar{Z}_0 \cdot \Delta\bar{U}_0 \cdot \bar{Y}_{0Fd})*q - \text{imag}(\Delta\bar{U}_0 \cdot \bar{Y}_{0Fd})*\text{real}(\bar{Z}_0 \cdot \Delta\bar{U}_0 \cdot \bar{Y}_{0Fd})*q - \text{imag}(\bar{Z}_0 \cdot \Delta\bar{U}_0 \cdot \bar{Y}_{0Fd})*q*\text{real}(\Delta\bar{I}_0) + \text{imag}(\bar{Z}_0 \cdot \Delta\bar{U}_0 \cdot \bar{Y}_{0Fd})*q*\text{real}(\Delta\bar{U}_0 \cdot \bar{Y}_{0Fd}));$

$b = (2* \text{imag}(\Delta\bar{I}_0)*\text{real}(\bar{Z}_1 \cdot \Delta\bar{U}_0 \cdot \bar{Y}_{0Fd}) - \text{imag}(\Delta\bar{I}_0)*\text{real}(\bar{Z}_0 \cdot \Delta\bar{I}_0) + \text{imag}(\Delta\bar{U}_0 \cdot \bar{Y}_{0Fd})*\text{real}(\bar{Z}_0 \cdot \Delta\bar{I}_0) - 2*\text{imag}(\Delta\bar{I}_0)*\text{real}(Z_1 \cdot \Delta\bar{I}_0) + 2*\text{imag}(\Delta\bar{U}_0 \cdot \bar{Y}_{0Fd})*\text{real}(\bar{Z}_1 \cdot \Delta\bar{I}_0) - 2*\text{imag}(\Delta\bar{U}_0 \cdot \bar{Y}_{0Fd})*\text{real}(\bar{Z}_1 \cdot \Delta\bar{U}_0 \cdot \bar{Y}_{0Fd}) - 2*\text{real}(\Delta\bar{I}_0)*\text{imag}(\bar{Z}_1 \cdot \Delta\bar{U}_0 \cdot \bar{Y}_{0Fd}) + 2*\text{real}(\Delta\bar{U}_0 \cdot \bar{Y}_{0Fd})*\text{imag}(\bar{Z}_1 \cdot \Delta\bar{U}_0 \cdot \bar{Y}_{0Fd}) + \text{real}(\Delta\bar{I}_0)*\text{imag}(\bar{Z}_0 \cdot \Delta\bar{I}_0) - \text{real}(\Delta\bar{U}_0 \cdot \bar{Y}_{0Fd})*\text{imag}(\bar{Z}_0 \cdot \Delta\bar{I}_0) + 2*\text{real}(\Delta\bar{I}_0)*\text{imag}(\bar{Z}_1 \cdot \Delta\bar{I}_0) - 2*\text{real}(\Delta\bar{U}_0 \cdot \bar{Y}_{0Fd})*\text{imag}(\bar{Z}_1 \cdot \Delta\bar{I}_0));$ and

$c = \text{imag}(\Delta\bar{I}_0)*\text{real}(\Delta\bar{U}_0) - \text{imag}(\Delta\bar{U}_0 \cdot \bar{Y}_{0Fd})*\text{real}(\Delta\bar{U}_0) - \text{imag}(\Delta\bar{U}_0)*\text{real}(\Delta\bar{I}_0) + \text{imag}(\Delta\bar{U}_0)*\text{real}(\Delta\bar{U}_0 \cdot \bar{Y}_{0Fd}),$

where

$\bar{Z}_0$ = zero-sequence impedance of the electric line

$\bar{Z}_1$ = positive-sequence impedance of the electric line

$\bar{Y}_{0Fd}$ = admittance of the electric line

$\Delta\bar{U}_0$ = change in the residual voltage when the neutral to earth admittance of the electric network changes from the first value to the second value

$\Delta\bar{I}_0$ = change in the zero-sequence current when the neutral to earth admittance of the electric network changes from the first value to the second value

q = parameter and $0<q\leq1$.

8.  An apparatus as claimed in claim 7, **characterized in that**

$$d1 = \frac{-b + \sqrt{b^2 - 4 \cdot a \cdot c}}{2 \cdot a} ;$$

and

$$d2 = \frac{-b - \sqrt{b^2 - 4 \cdot a \cdot c}}{2 \cdot a} ,$$

wherein the means (40) for determining the distance are configured to determine the distance d to the phase-to-earth fault from the measuring point as follows: d = d1 if $0\leq d1\leq1$, otherwise d = d2.

9.  An apparatus as claimed in claim 7 or 8, **characterized in that** the apparatus comprises means (40) for detecting the change in the neutral to earth admittance of the electric network outside the electric line (30) from the first value to the second value by monitoring a resistive current component of a residual current of the electric line (30).

10. An apparatus as claimed in claim 9, **characterized in that** the means (40) for detecting the change in the neutral to earth admittance of the electric network outside the electric line (30) are configured to determine the neutral to earth admittance of the electric network outside the electric line to have changed from the first value to the second value when the resistive current component of the residual current of the electric line (30) changes at least by a predetermined threshold.

11. An apparatus as claimed in any one of claims 7 to 10, **characterized in that** q is approximately 0.5.

12. An apparatus as claimed in any one of claims 7 to 11, **characterized in that** the apparatus comprises a protective relay.

**Patentansprüche**

1. Ein Verfahren zur Bestimmung der Distanz zu einem einphasigen Erdschluss einer dreiphasigen elektrischen Leitung eines elektrischen Netzwerks, wobei das Verfahren Folgendes aufweist:

   während eines einphasigen Erdschlusses (F) auf der dreiphasigen elektrischen Leitung (30) Werte einer Restspannung des elektrischen Netzwerks und einen Nullstrom der elektrischen Leitung an einem Messpunkt (40) bestimmen, wenn eine neutral-zu-Erde-Admittanz des elektrischen Netzwerks außerhalb der elektrischen Leitung (30) einen ersten Wert hat und wenn die neutral-zu-Erde-Admittanz des elektrischen Netzwerks außerhalb der elektrischen Leitung einen zweiten Wert hat, der sich von dem ersten Wert unterscheidet; und
   die Distanz zum einphasigen Erdschluss (F) von dem Messpunkt (40) auf der Basis der bestimmten Restspannungswerte und der Nullstromwerte bestimmen, **dadurch gekennzeichnet , dass** die Distanz bestimmt wird, indem die folgende Gleichung verwendet wird:

$$a*d^2 + b*d + c = 0$$

   wobei

   d = Distanz zum Schluss in pro Einheit (p.u.)
   $a = (\text{imag}(\Delta \bar{I}_0)*\text{real}(\bar{Z}_0 \cdot \Delta \bar{U}_0 \cdot \bar{Y}_{0Fd})*q - \text{imag}(\Delta \bar{U}_0 \cdot \bar{Y}_{0Fd})*\text{real}(\bar{Z}_0 \cdot \Delta \bar{U}_0 \cdot \bar{Y}_{0Fd})*q - \text{imag}(\bar{Z}_0 \cdot \Delta \bar{U}_0 \cdot \bar{Y}_{0Fd})$
   $*q*\text{real}(\Delta \bar{I}_0) + \text{imag}(\bar{Z}_0 \cdot \Delta \bar{U}_0 \cdot \bar{Y}_{0Fd})*q*\text{real}(\Delta \bar{U}_0 \cdot \bar{Y}_{0Fd}));$
   $b = (2* \text{imag}(\Delta \bar{I}_0)*\text{real}(\bar{Z}_1 \cdot \Delta \bar{U}_0 \cdot \bar{Y}_{0Fd}) - \text{imag}(\Delta \bar{I}_0)*\text{real}(\bar{Z}_0 \cdot \Delta \bar{I}_0) + \text{imag}(\Delta \bar{U}_0 \cdot \bar{Y}_{0Fd})*\text{real}(\bar{Z}_0 \cdot \Delta \bar{I}_0) - 2*\text{imag}$
   $(\Delta \bar{I}_0)*\text{real}(\bar{Z}_1 \cdot \Delta \bar{I}_0) + 2*\text{imag}(\Delta \bar{U}_0 \cdot \bar{Y}_{0Fd})*\text{real}(\bar{Z}_1 \cdot \Delta \bar{I}_0) - 2*\text{imag}(\Delta \bar{U}_0 \cdot \bar{Y}_{0Fd})*\text{real}(\bar{Z}_1 \cdot \Delta \bar{U}_0 \cdot \bar{Y}_{0Fd}) - 2*\text{real}(\Delta \bar{I}_0)$
   $*\text{imag}(\bar{Z}_1 \cdot \Delta \bar{U}_0 \cdot \bar{Y}_{0Fd}) + 2*\text{real}(\Delta \bar{U}_0 \cdot \bar{Y}_{0Fd})*\text{imag}(\bar{Z}_1 \cdot \Delta \bar{U}_0 \cdot \bar{Y}_{0Fd}) + \text{real}(\Delta \bar{I}_0)*\text{imag}(\bar{Z}_0 \cdot \Delta \bar{I}_0) - \text{real}(\Delta \bar{U}_0 \cdot \bar{Y}_{0Fd})$
   $*\text{imag}(\bar{Z}_0 \cdot \Delta \bar{I}_0) + 2*\text{real}(\Delta \bar{I}_0)*\text{imag}(\bar{Z}_1 \cdot \Delta \bar{I}_0) - 2*\text{real}(\Delta \bar{U}_0 \cdot \bar{Y}_{0Fd})*\text{imag}(\bar{Z}_1 \cdot \Delta \bar{I}_0));$ and
   $c = \text{imag}(\Delta \bar{I}_0)*\text{real}(\Delta \bar{U}_0) - \text{imag}(\Delta \bar{U}_0 \cdot \bar{Y}_{0Fd})*\text{real}(\Delta \bar{U}_0) - \text{imag}(\Delta \bar{U}_0)*\text{real}(\Delta \bar{I}_0) + \text{imag}(\Delta \bar{U}_0)*\text{real}(\Delta \bar{U}_0 \cdot \bar{Y}_{0Fd}),$

   wobei

   $\bar{Z}_0$ = Nullimpedanz der elektrischen Leitung
   $\bar{Z}_1$ = Mitimpedanz der elektrischen Leitung
   $\bar{Y}_{0Fd}$ = Admittanz der elektrischen Leitung
   $\Delta \bar{U}_0$ = Veränderung in der Restspannung, wenn sich die neutral-zu-Erde-Admittanz des elektrischen Netzwerks von dem ersten Wert zu dem zweiten Wert verändert
   $\Delta \bar{I}_0$ = Veränderung in dem Nullstrom, wenn sich die neutral-zu-Erde-Admittanz des elektrischen Netzwerks von dem ersten Wert zu dem zweiten Wert verändert
   q = Parameter und $0 < q \leq 1$.

2. Ein Verfahren gemäß dem Patentanspruch 1, dadurch g e - kennzeichnet, dass

$$d1 = \frac{-b + \sqrt{b^2 - 4 \cdot a \cdot c}}{2 \cdot a} ;$$

   und

$$d2 = \frac{-b - \sqrt{b^2 - 4 \cdot a \cdot c}}{2 \cdot a} ,$$

   wobei die Distanz d zu dem einphasigen Erdschluss (F) von dem Messpunkt (40) wie folgt bestimmt wird: d = d1 wenn $0 \leq d1 \leq 1$, sonst d = d2.

3. Ein Verfahren gemäß dem Patentanspruch 1 oder 2, **dadurch gekennzeichnet , dass** die Veränderung in der neutral-zu-Erde-Admittanz des elektrischen Netzwerks außerhalb der elektrischen Leitung (30) von dem ersten Wert zu dem zweiten Wert erfasst wird, indem eine Widerstandsstromkomponente eines Reststroms der elektrischen Leitung (30) überwacht wird.

4. Ein Verfahren gemäß dem Patentanspruch 3, **dadurch gekennzeichnet, dass** die neutral-zu-Erde-Admittanz des elektrischen Netzwerks außerhalb der elektrischen Leitung (30) bestimmt ist, sich von dem ersten Wert zu dem zweiten Wert verändert zu haben, wenn sich die Widerstandsstromkomponente des Reststroms der elektrischen Leitung (30) mindestens um eine im Voraus bestimmte Schwelle verändert.

5. Ein Verfahren gemäß einem der Patentansprüche 1 bis 4, **dadurch gekennzeichnet, dass** q etwa 0,5 beträgt.

6. Ein Computerprogrammprodukt, welches einen Computerprogrammkode aufweist, wobei ein Durchführen des Programmkodes in einem Computer den Computer veranlasst, die Schritte des Verfahrens gemäß einem der Patentansprüche 1 bis 5 auszuführen.

7. Eine Anordnung zum Bestimmen der Distanz zu einem einphasigen Erdschluss auf einer dreiphasigen elektrischen Leitung eines elektrischen Netzwerks, wobei die Anordnung Folgendes aufweist:

Mittel (40) zum Bestimmen von Werten einer Restspannung des elektrischen Netzwerks und eines Nullstroms der elektrischen Leitung an einem Messpunkt (40) während eines einphasigen Erdschlusses (F) auf der dreiphasigen elektrischen Leitung (30), wenn eine neutral-zu-Erde-Admittanz des elektrischen Netzwerks außerhalb der elektrischen Leitung (30) einen ersten Wert hat und wenn die neutral-zu-Erde-Admittanz des elektrischen Netzwerks außerhalb der elektrischen Leitung einen zweiten Wert hat, der sich von dem ersten Wert unterscheidet; und

Mittel (40) zum Bestimmen der Distanz zu dem einphasigen Erdschluss (F) von dem Messpunkt (40) auf der Basis der bestimmten Restspannung und der Nullstromwerte, **dadurch gekennzeichnet , dass** die Mittel (40) zum Bestimmen der Distanz konfiguriert sind, die Distanz zu bestimmen, indem folgende Gleichung verwendet wird:

$$a*d^2 + b*d + c = 0$$

wobei

$d$ = Distanz zum Schluss in pro Einheit (p.u.)

$a = (\text{imag}(\Delta\bar{I}_0)*\text{real}(\bar{Z}_0 \cdot \Delta\bar{U}_0 \cdot \bar{Y}_{0Fd})*q \ \text{imag}(\Delta\bar{U}_0 \cdot \bar{Y}_{0Fd})*\text{real}(\bar{Z}_0 \cdot \Delta\bar{U}_0 \cdot \bar{Y}_{0Fd})*q - \text{imag}(\bar{Z}_0 \cdot \Delta\bar{U}_0 \cdot \bar{Y}_{0Fd})*q*\text{real}(\Delta\bar{I}_0) + \text{imag}(\bar{Z}_0 \cdot \Delta\bar{U}_0 \cdot \bar{Y}_{0Fd})*q*\text{real}(\Delta\bar{U}_0 \cdot \bar{Y}_{0Fd}));$

$b = (2* \ \text{imag}(\Delta\bar{I}_0)*\text{real}(\bar{Z}_1 \cdot \Delta\bar{U}_0 \cdot \bar{Y}_{0Fd}) - \text{imag}(\Delta\bar{I}_0)*\text{real}(\bar{Z}_0 \cdot \Delta\bar{I}_0) + \text{imag}(\Delta\bar{U}_0 \cdot \bar{Y}_{0Fd})*\text{real}(\bar{Z}_0 \cdot \Delta\bar{I}_0) - 2*\text{imag}(\Delta\bar{I}_0)*\text{real}(\bar{Z}_1 \cdot \Delta\bar{I}_0) + 2*\text{imag}(\Delta\bar{U}_0 \cdot \bar{Y}_{0Fd})*\text{real}(\bar{Z}_1 \cdot \Delta\bar{I}_0) - 2*\text{imag}(\bar{Z}_0 \cdot \Delta\bar{U}_0 \cdot \bar{Y}_{0Fd})*\text{real}(\bar{Z}_1 \cdot \Delta\bar{U}_0 \cdot \bar{Y}_{0Fd}) - 2*\text{real}(\Delta\bar{I}_0)*\text{imag}(\bar{Z}_1 \cdot \Delta U_0 \cdot \bar{Y}_{0Fd}) + 2*\text{real}(\Delta\bar{U}_0 \cdot \bar{Y}_{0Fd})*\text{imag}(\bar{Z}_1 \cdot \Delta\bar{U}_0 \cdot \bar{Y}_{0Fd}) + \text{real}(\Delta\bar{I}_0)*\text{imag}(\bar{Z}_0 \cdot \Delta\bar{I}_0) - \text{real}(\Delta\bar{U}_0 \cdot \bar{Y}_{0Fd})*\text{imag}(\bar{Z}_0 \cdot \Delta\bar{I}_0) + 2*\text{real}(\Delta\bar{I}_0)*\text{imag}(\bar{Z}_1 \cdot \Delta\bar{I}_0) - 2*\text{real}(\Delta\bar{U}_0 \cdot \bar{Y}_{0Fd})*\text{imag}(\bar{Z}_1 \cdot \Delta\bar{I}_0));$ and

$c = \text{imag}(\Delta\bar{I}_0)*\text{real}(\Delta\bar{U}_0) - \text{imag}(\Delta\bar{U}_0 \cdot \bar{Y}_{0Fd})*\text{real}(\Delta\bar{U}_0) - \text{imag}(\Delta\bar{U}_0)*\text{real}(\bar{Z}_0 \cdot \Delta\bar{I}_0) + \text{imag}(\Delta\bar{U}_0)*\text{real}(\Delta\bar{U}_0 \cdot \bar{Y}_{0Fd}),$

wobei

$\bar{Z}_0$ = Nullimpedanz der elektrischen Leitung

$\bar{Z}_1$ = Mitimpedanz der elektrischen Leitung

$\bar{Y}_{0Fd}$ = Admittanz der elektrischen Leitung

$\Delta\bar{U}_0$ = Veränderung in der Restspannung, wenn sich die neutral-zu-Erde-Admittanz des elektrischen Netzwerks von dem ersten Wert zu dem zweiten Wert verändert

$\Delta\bar{I}_0$ = Veränderung in dem Nullstrom, wenn sich die neutral-zu-Erde-Admittanz des elektrischen Netzwerks von dem ersten Wert zu dem zweiten Wert verändert

$q$ = Parameter und $0 < q \leq 1$.

8. Eine Anordnung gemäß dem Patentanspruch 7, **dadurch gekennzeichnet, dass**

$$d1 = \frac{-b + \sqrt{b^2 - 4 \cdot a \cdot c}}{2 \cdot a};$$

und

$$d2 = \frac{-b - \sqrt{b^2 - 4 \cdot a \cdot c}}{2 \cdot a},$$

wobei die Mittel (40) zum Bestimmen der Distanz konfiguriert sind, die Distanz d zu dem einphasigen Erdschluss von dem Messpunkt wie folgt zu bestimmen: d = d1 wenn 0≤d1≤1, sonst d = d2.

9. Eine Anordnung gemäß dem Patentanspruch 7 oder 8, **dadurch gekennzeichnet , dass** die Anordnung Mittel (40) aufweist, um die Veränderung in der neutral-zu-Erde-Admittanz des elektrischen Netzwerks außerhalb der elektrischen Leitung (30) von dem ersten Wert zu dem zweiten Wert zu erfassen, indem eine Widerstandsstromkomponente eines Reststroms der elektrischen Leitung (30) überwacht wird.

10. Eine Anordnung gemäß dem Patentanspruch 9, **dadurch gekennzeichnet,dass** die Mittel (40) zum Erfassen der Veränderung in der neutral-zu-Erde-Admittanz des elektrischen Netzwerks außerhalb der elektrischen Leitung (30) konfiguriert sind, zu bestimmen, dass sich die neutral-zu-Erde-Admittanz des elektrischen Netzwerks außerhalb der elektrischen Leitung von dem ersten Werte zu dem zweiten Wert verändert hat, wenn sich die Widerstandsstromkomponente des Reststroms der elektrischen Leitung (30) mindestens um eine im Voraus bestimmte Schwelle verändert.

11. Eine Anordnung gemäß einem der Patentansprüche 7 bis 10, **dadurch gekennzeichnet, dass** q etwa 0,5 beträgt.

12. Eine Anordnung gemäß einem der Patentansprüche 7 bis 11, **dadurch gekennzeichnet, dass** die Anordnung ein Schutzrelais aufweist.

## Revendications

1. Méthode pour déterminer une distance à un défaut à la terre sur une ligne électrique triphasée d'un réseau électrique, la méthode comprenant de :

    déterminer, pendant un défaut à la terre (F) sur la ligne électrique triphasée (30), des valeurs d'une tension résiduelle du réseau électrique et d'un courant homopolaire de la ligne électrique au niveau d'un point de mesure (40) lorsque une admittance entre neutre et terre du réseau électrique à l'extérieur de la ligne électrique (30) a une première valeur et lorsque l'admittance entre neutre et terre du réseau électrique à l'extérieur de la ligne électrique a une seconde valeur différente de la première valeur ; et
    déterminer la distance au défaut à la terre (F) depuis le point de mesure (40) sur la base des valeurs de tension résiduelle et de courant homopolaire déterminées,
    **caractérisée en ce que** la distance est déterminée en utilisant l'équation suivante :

$$a*d^2 + b*d + c = 0$$

    dans laquelle

    d = distance au défaut en par unité (p.u.)
    a = $(\mathrm{Im}(\Delta \bar{I}_0)^*{}_{Re}(\bar{Z}_0 \cdot \Delta \bar{U}_0 \cdot \bar{Y}_{0Fd})^*q - \mathrm{Im}(\Delta \bar{U}_0 \cdot \bar{Y}_{0Fd})^*{}_{Re}(Z_0 \cdot \bar{Z}_0 \cdot \Delta \bar{U}_0 \cdot \bar{Y}_{0Fd})^*q - \mathrm{Im}(\bar{Z}_0 \cdot \Delta \bar{U}_0 \cdot \bar{Y}_{0Fd})^*q*\mathrm{Re}(\Delta \bar{I}_0)$

**13**

$+ \text{Im}(\overline{Z}_0 \cdot \Delta\overline{U}_0 \cdot \overline{Y}_{0Fd})\text{*}q\text{*}\text{Re}(\Delta\overline{U}_0 \cdot \overline{Y}_{0d}))$;

$b = (2\text{*}\ \text{Im}(\Delta\overline{I}_0)\text{*}\text{Re}(\overline{Z}_1 \cdot \Delta\overline{U}_0 \cdot \overline{Y}_{0Fd}) - \text{Im}(\Delta\overline{I}_0)\text{*}\text{Re}(\overline{Z}_0 \cdot \Delta\overline{I}_0) + \text{Im}(\Delta\overline{U}_0 \cdot \overline{Y}_{0Fd})\text{*}\text{Re}(\overline{Z}_0 \cdot \Delta\overline{I}_0) - 2\text{*}\text{Im}(\Delta\overline{I}_0)\text{*}\text{Re}(\overline{Z}_1 \cdot \Delta\overline{I}_0) + 2\text{*}\text{Im}(\Delta\overline{U}_0 \cdot \overline{Y}_{0Fd})\text{*}\text{Re}(\overline{Z}_1 \cdot \Delta\overline{I}_0) - 2\text{*}\text{Im}(\Delta\overline{U}_0 \cdot \overline{Y}_{0Fd})\text{*}\text{Re}(\overline{Z}_1 \cdot \Delta\overline{U}_0 \cdot \overline{Y}_{0Fd}) - 2\text{*}\text{Re}(\Delta\overline{I}_0)\text{*}\text{Im}(\overline{Z}_1 \cdot \Delta\overline{U}_0 \cdot \overline{Y}_{0Fd}) + 2\text{*}\text{Re}(\Delta\overline{U}_0 \cdot \overline{Y}_{0Fd})\text{*}\text{Im}(\overline{Z}_1 \cdot \Delta\overline{U}_0 \cdot \overline{Y}_{0Fd}) + \text{Re}(\Delta\overline{I}_0)\text{*}\text{Im}(\overline{Z}_0 \cdot \Delta\overline{I}_0) - \text{Re}(\Delta\overline{U}_0 \cdot \overline{Y}_{0Fd})\text{*}\text{im}(\overline{Z}_0 \cdot \Delta\overline{I}_0) + 2\text{*}\text{Re}(\Delta\overline{I}_0)\text{*}\text{Im}(\overline{Z}_1 \cdot \Delta\overline{I}_0) - 2\text{*}\text{Re}(\Delta\overline{U}_0 \cdot \overline{Y}_{0Fd})\text{*}\text{Im}(\overline{Z}_1 \cdot \Delta\overline{I}_0))$ ; et

$c = \text{Im}(\Delta\overline{I}_0)\text{*}\text{Re}(\Delta\overline{U}_0) - \text{Im}(\Delta\overline{U}_0 \cdot \overline{Y}_{0Fd})\text{*}\text{Re}(\Delta\overline{U}_0) - \text{Im}(\Delta\overline{U}_0)\text{*}\text{Re}(\Delta\overline{I}_0) + \text{Im}(\Delta\overline{U}_0)\text{*}\text{Re}(\Delta\overline{U}_0 \cdot \overline{Y}_{0Fd})$,

où

$\overline{Z}_0$ = impédance homopolaire de la ligne électrique
$\overline{Z}_1$ = impédance de séquence positive de la ligne électrique
$\overline{Y}_{0Fd}$ = admittance de la ligne électrique
$\Delta\overline{U}_0$ = changement dans la tension résiduelle lorsque l'admittance entre neutre et terre du réseau électrique change de la première valeur à la seconde valeur
$\Delta\overline{I}_0$ = changement dans le courant homopolaire lorsque l'admittance entre neutre et terre du réseau électrique change de la première valeur à la seconde valeur
q = paramètre et $0<q\leq1$.

2. Méthode selon la revendication 1, **caractérisée en ce que**

$$d1 = \frac{-b + \sqrt{b^2 - 4 \cdot a \cdot c}}{2 \cdot a}\ ;$$

et

$$d2 = \frac{-b - \sqrt{b^2 - 4 \cdot a \cdot c}}{2 \cdot a},$$

dans laquelle la distance d au défaut à la terre (F) depuis le point de mesure (40) est déterminée comme suit : d = d1 si $0\leq d1\leq1$, autrement d = d2.

3. Méthode selon la revendication 1 ou la revendication 2, **caractérisée en ce que** le changement dans l'admittance entre neutre et terre du réseau électrique à l'extérieur de la ligne électrique (30) de la première valeur à la seconde valeur est détecté en surveillant un composant de courant résistif d'un courant résiduel de la ligne électrique (30).

4. Méthode selon la revendication 3, **caractérisée en ce que** l'admittance entre neutre et terre du réseau électrique à l'extérieur de la ligne électrique (30) est déterminée avoir changé de la première valeur à la seconde valeur lorsque le composant de courant résistif du courant résiduel de la ligne électrique (30) change d'au moins un seuil prédéterminé.

5. Méthode selon l'une quelconque des revendications 1 à 4, **caractérisée en ce que** q est approximativement 0,5.

6. Produit de programme d'ordinateur comprenant du code de programme d'ordinateur, dans lequel l'exécution du code de programme dans un ordinateur fait exécuter à l'ordinateur les étapes de la méthode selon l'une quelconque des revendications 1 à 5.

7. Appareil pour déterminer une distance à un défaut à la terre sur une ligne électrique triphasée d'un réseau électrique, l'appareil comprenant :

des moyens (40) pour déterminer, pendant un défaut à la terre (F) sur la ligne électrique triphasée (30), des valeurs d'une tension résiduelle du réseau électrique et d'un courant homopolaire de la ligne électrique au niveau d'un point de mesure (40) lorsque une admittance entre neutre et terre du réseau électrique à l'extérieur de la ligne électrique (30) a une première valeur et lorsque l'admittance entre neutre et terre du réseau électrique à l'extérieur de la ligne électrique a une seconde valeur différente de la première valeur ; et

des moyens (40) pour déterminer la distance au défaut à la terre (F) depuis le point de mesure (40) sur la base des valeurs de tension résiduelle et de courant homopolaire déterminées,
**caractérisé en ce que** les moyens (40) pour déterminer la distance sont configurés pour déterminer la distance en utilisant l'équation suivante :

$$a*d^2 + b*d + c = 0$$

dans laquelle

d = distance au défaut en par unité (p.u.)
$a = (\text{Im}(\Delta \bar{I}_0)*\text{Re}(\bar{Z}_0 \cdot \Delta \bar{U}_0 \cdot \bar{Y}_{0Fd})*q - \text{Im}(\Delta \bar{U}_0 \cdot \bar{Y}_{0Fd})*\text{Re}(Z_0 \cdot \Delta \bar{U}_0 \cdot \bar{Y}_{0Fd})*q - \text{Im}(\bar{Z}_0 \cdot \Delta \bar{U}_0 \cdot \bar{Y}_{0Fd})*q*\text{Re}(\Delta \bar{I}_0) + \text{Im}(\bar{Z}_0 \cdot \Delta \bar{U}_0 \cdot \bar{Y}_{0Fd})*q*\text{Re}(\Delta \bar{U}_0 \cdot \bar{Y}_{0Fd}) -$
$b = (2* \text{Im}(\Delta \bar{I}_0)*\text{Re}(\bar{Z}_1 \cdot \Delta \bar{U}_0 \cdot \bar{Y}_{0Fd}) - \text{Im}(\Delta \bar{I}_0)*\text{Re}(\bar{Z}_0 \cdot \Delta \bar{I}_0) + \text{Im}(\Delta \bar{U}_0 \cdot \bar{Y}_{0Fd}) - 2*\text{Im}(\Delta \bar{I}_0)*\text{Re}(\bar{Z}_1 \cdot \Delta \bar{I}_0) + 2*\text{Im}(\Delta \bar{U}_0 \cdot \bar{Y}_{0Fd})*\text{Re}(\bar{Z}_1 \cdot \Delta \bar{I}_0) - 2*\text{Im}(\Delta \bar{U}_0 \cdot \bar{Y}_{0Fd})*\text{Re}(\bar{Z}_1 \cdot \Delta \bar{U}_0 \cdot \bar{Y}_{0Fd}) - 2*\text{Re}(\Delta \bar{I}_0)*\text{Im}(\bar{Z}_1 \cdot \Delta \bar{U}_0 \cdot \bar{Y}_{0Fd}) + 2*\text{Re}(\Delta \bar{U}_0 \cdot \bar{Y}_{0Fd})*\text{Im}(\bar{Z}_1 \cdot \Delta \bar{U}_0 \cdot \bar{Y}_{0Fd}) + \text{Re}(\Delta \bar{I}_0)*\text{Im}(\bar{Z}_0 \cdot \Delta \bar{I}_0) - \text{Re}(\Delta \bar{U}_0 \cdot \bar{Y}_{0Fd})*\text{im}(\bar{Z}_0 \cdot \Delta \bar{I}_0) + 2*\text{Re}(\Delta \bar{I}_0)*\text{Im}(\bar{Z}_1 \cdot \Delta \bar{I}_0) - 2*\text{Re}(\Delta \bar{U}_0 \cdot \bar{Y}_{0Fd})*\text{Im}(\bar{Z}_1 \cdot \Delta \bar{I}_0))$ ; et
$c = \text{Im}(\Delta \bar{I}_0)*\text{Re}(\Delta \bar{U}_0) - \text{Im}(\Delta \bar{U}_0 \cdot \bar{Y}_{0Fd})*\text{Re}(\Delta \bar{U}_0) - \text{Im}(\Delta \bar{U}_0)*\text{Re}(\Delta \bar{I}_0) + \text{Im}(\Delta \bar{U}_0)*\text{Re}(\Delta \bar{U}_0 \cdot \bar{Y}_{0Fd})$,

où

$\bar{Z}_0$ = impédance homopolaire de la ligne électrique
$\bar{Z}_1$ = impédance de séquence positive de la ligne électrique
$\bar{Y}_{0Fd}$ = admittance de la ligne électrique
$\Delta \bar{U}_0$ = changement dans la tension résiduelle lorsque l'admittance entre neutre et terre du réseau électrique change de la première valeur à la seconde valeur
$\Delta \bar{I}_0$ = changement dans le courant homopolaire lorsque l'admittance entre neutre et terre du réseau électrique change de la première valeur à la seconde valeur
q = paramètre et 0<q≤1.

8. Appareil selon la revendication 7, **caractérisé en ce que**

$$d1 = \frac{-b + \sqrt{b^2 - 4 \cdot a \cdot c}}{2 \cdot a} \; ;$$

et

$$d2 = \frac{-b - \sqrt{b^2 - 4 \cdot a \cdot c}}{2 \cdot a} \, ,$$

dans lequel les moyens (40) pour déterminer la distance sont configurés pour déterminer la distance d au défaut à la terre depuis le point de mesure comme suit : d = d1 si 0≤d1≤1, autrement d = d2.

9. Appareil selon la revendication 7 ou la revendication 8, **caractérisé en ce que** l'appareil comprend des moyens (40) pour détecter le changement dans l'admittance entre neutre et terre du réseau électrique à l'extérieur de la ligne électrique (30) de la première valeur à la seconde valeur en surveillant un composant de courant résistif d'un courant résiduel de la ligne électrique (30).

10. Appareil selon la revendication 9, **caractérisé en ce que** les moyens (40) pour détecter le changement dans l'admittance entre neutre et terre du réseau électrique à l'extérieur de la ligne électrique (30) sont configurés pour déterminer que l'admittance entre neutre et terre du réseau électrique à l'extérieur de la ligne électrique a changé de la première valeur à la seconde valeur lorsque le composant de courant résistif du courant résiduel de la ligne électrique (30) change d'au moins un seuil prédéterminé.

**11.** Appareil selon l'une quelconque des revendications 7 à 10, **caractérisé en ce que** q est approximativement 0,5.

**12.** Appareil selon l'une quelconque des revendications 7 à 11, **caractérisé en ce que** l'appareil comprend un relai de protection.

Fig. 1

Fig. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1304580 A

**Non-patent literature cited in the description**

- Earth fault distance computation with fundamental frequency signals based on measurements in substation supply bay. *Seppo Hänninen, Matti Lehtonen; VTT Research Notes 2153,* 2002